# EUROPÄISCHE PATENTSCHRIFT

(11) **EP 3 564 584 B1**
(45) Veröffentlichungstag und Bekanntmachung des Hinweises auf die Patenterteilung: **23.08.2023**
(21) Anmeldenummer: 18170888.4
(22) Anmeldetag: 04.05.2018
(51) Int. Cl.: F23Q 23/00, G07C 3/08, F02P 17/00

(54) **EINRICHTUNG ZUR ERFASSUNG EINES EIN-ZUSTANDS EINES ANTRIEBSMOTORS EINES WERKZEUGS UND SYSTEM**
SYSTEM FOR LOCATING AN ON STATE OF A DRIVE MOTOR OF A TOOL AND SYSTEM
DISPOSITIF DE DÉTECTION D'UN ÉTAT DE MARCHE D'UN MOTEUR D'ENTRAÎNEMENT D'UN OUTIL ET SYSTÈME

(43) Veröffentlichungstag der Anmeldung: 06.11.2019
(73) Patentinhaber: Andreas Stihl AG & Co. KG, 71336 Waiblingen (DE)
(72) Erfinder: GURR, Kay-Steffen, 74078 Heilbronn (DE); VAAS, André, 73489 Jagstzell (DE); SÄMANN, Rudolf, 72336 Balingen (DE); SÄMANN, Marc, 72336 Balingen (DE)
(74) Vertreter: Patentanwälte Ruff, Wilhelm, Beier, Dauster & Partner mbB

(56) Entgegenhaltungen:
- EP-A1- 3 291 181
- DE-A1- 10 257 841
- US-A1- 2014 240 125

## Beschreibung

### ANWENDUNGSGEBIET UND STAND DER TECHNIK

Die Erfindung betrifft eine Einrichtung zur Erfassung eines Ein-Zustands eines Antriebsmotors eines Werkzeugs und ein System mit einer solchen Einrichtung und einem Werkzeug aufweisend einen Antriebsmotor und/oder einem Endgerät.

Die EP 3 291 181 A1 offenbart ein Gerät zur Erfassung von Betriebsdaten eines Werkzeugs.

Die DE 102 57 841 A1 offenbart eine elektrische Schaltung zur Verarbeitung eines von einem Sensor erzeugten potentialfreien Signals, insbesondere eines von einem induktiven Sensor erzeugten potentialfreien Drehzahlsignals beispielsweise einer Brennkraftmaschine. Die elektrische Schaltung weist zwei Leitungen auf, die mit dem Sensor gekoppelt sind und zwischen denen ein von dem potentialfreien Signal des Sensors abhängiges Signal vorhanden ist. Weiterhein weist die elektrische Schaltung einen ersten Komparator auf, dessen einer Eingang mit einer der beiden Leitungen gekoppelt ist und dessen anderer Eingang von einem Schwellwert beaufschlagt ist. Die elektrische Schaltung weist einen Spitzenwert-Gleichrichter auf, mit dem der den ersten Komparator beaufschlagende Schwellwert in Abhängigkeit von dem zwischen den Leitungen vorhandenen Signal beeinflussbar ist.

### AUFGABE UND LÖSUNG

Der Erfindung liegt als Aufgabe die Bereitstellung einer Einrichtung zur Erfassung eines Ein-Zustands eines Antriebsmotors eines Werkzeugs, die gut erfasst und energiesparend und flexibel ist, und eines Systems mit einer solchen Einrichtung und einem Werkzeug aufweisend einen Antriebsmotor und/oder einem Endgerät zugrunde.

Die Erfindung löst diese Aufgabe durch die Bereitstellung einer Einrichtung mit den Merkmalen des Anspruchs 1 und eines Systems mit den Merkmalen des Anspruchs 12 und/oder des Anspruchs 14. Vorteilhafte Weiterbildungen und/oder Ausgestaltungen der Erfindung sind in den abhängigen Ansprüchen beschrieben.

Die erfindungsgemäße Einrichtung ist zur, insbesondere automatischen, Erfassung beziehungsweise Detektion eines Ein-Zustands, insbesondere einer, insbesondere von Null verschiedenen, Drehzahl, eines Antriebsmotors eines Werkzeugs ausgebildet. Die Einrichtung ist zur Anordnung an, insbesondere in, dem Werkzeug ausgebildet. Im Ein-Zustand, insbesondere bei der, insbesondere von Null verschiedenen, Drehzahl, des Antriebsmotors wird ein sich, insbesondere zeitlich, ändernder magnetischer Fluss bewirkt, insbesondere nur im Ein-Zustand. Die Einrichtung weist einen, insbesondere elektrischen, induktiven Sensor, einen, insbesondere elektrischen, Kondensator, einen, insbesondere elektrischen, Verstärker, einen, insbesondere elektrischen, ersten Peak-Hold-Detektor, einen, insbesondere elektrischen, zweiten Peak-Hold-Detektor, eine, insbesondere elektrische, Auswerteeinrichtung und eine, insbesondere elektrische, Kommunikationsschnittstelle auf. Der induktive Sensor ist dazu ausgebildet, dass aufgrund des sich ändernden magnetischen Flusses in dem induktiven Sensor ein, insbesondere elektrisches, Spannungssignal induziert wird, insbesondere automatisch. Der Kondensator ist elektrisch mit dem induktiven Sensor verbunden. Der Verstärker ist dazu ausgebildet, das induzierte Spannungssignal oder ein auf dem Spannungssignal basierendes Signal in ein, insbesondere elektrisches, Ausgangsspannungssignal zu verstärken, insbesondere automatisch. Der erste Peak-Hold-Detektor ist dazu ausgebildet, aus dem Ausgangsspannungssignal oder einem auf dem Ausgangsspannungssignal basierenden Signal ein, insbesondere elektrisches, oberes Peaksignal zu erzeugen, insbesondere automatisch. Der zweite Peak-Hold-Detektor ist dazu ausgebildet, aus dem Ausgangsspannungssignal oder dem auf dem Ausgangsspannungssignal basierenden Signal ein, insbesondere elektrisches, unteres Peaksignal zu erzeugen, insbesondere automatisch. Die Auswerteeinrichtung ist dazu ausgebildet, aus dem erzeugten oberen Peaksignal und dem erzeugten unteren Peaksignal eine Differenz zu bilden, die gebildete Differenz, insbesondere einen Wert beziehungsweise einen Betrag der Differenz, oder eine auf der gebildeten Differenz basierende Größe, insbesondere einen Wert beziehungsweise einen Betrag der Größe, mit einem einstellbaren, insbesondere einem benutzereinstellbaren, Schwellwert zu vergleichen, wobei der Schwellwert softwareseitig ist, und bei Erreichung oder Überschreitung des Schwellwerts den Ein-Zustand, insbesondere die Drehzahl, des Antriebsmotors zu bestimmen beziehungsweise zu ermitteln, insbesondere automatisch. Die Kommunikationsschnittstelle ist dazu ausgebildet, den bestimmten Ein-Zustand, insbesondere die Drehzahl, und/oder auf dem Ein-Zustand basierende Betriebsdaten drahtlos zu einem Endgerät zu senden beziehungsweise zu übertragen, insbesondere automatisch.

Die Einrichtung beziehungsweise ihr Kondensator und ihre Peak-Hold-Detektoren ermöglichen eine relativ gute Erfassung des Ein-Zustands, insbesondere der Drehzahl, bei einem relativ niedrigen Energieverbrauch. Im Detail ermöglicht der Kondensator eine Nutzung eines Frequenzganges in Richtung höhere Frequenzen und somit, dass der Verstärker relativ langsam und somit relativ energiesparend und kostengünstig sein kann. Die Peak-Hold-Detektoren ermöglichen, beide Halbwellen des Ausgangsspannungssignals und/oder des auf dem Ausgangsspannungssignal basierenden Signals auswerten zu können. Des Weiteren ermöglicht die Einrichtung beziehungsweise ihre Auswerteeinrichtung beziehungsweise ihr einstellbarer Schwellwert eine relativ große Flexibilität, insbesondere eine Anpassung an das Werkzeug beziehungsweise seinen Antriebsmotor.

Zusätzlich kann die Einrichtung zur, insbesondere automatischen, Erfassung eines Aus-Zustands, insbesondere einer Drehzahl Null, des Antriebsmotors des Werkzeugs ausgebildet sein. Insbesondere braucht oder kann im Aus-Zustand des Antriebsmotors kein sich ändernder magnetischer Fluss bewirkt werden und im induktiven Sensor braucht oder kann kein Spannungssignal induziert werden. Zusätzlich oder alternativ kann die Auswerteeinrichtung dazu ausgebildet sein, bei Unterschreitung des Schwellwerts den Aus-Zustand des Antriebsmotors zu bestimmen, insbesondere automatisch. Weiter zusätzlich oder alternativ kann die Kommunikationsschnittstelle dazu ausgebildet sein, den bestimmten Aus-Zustand und/oder auf dem Aus-Zustand basierende Betriebsdaten drahtlos zu dem Endgerät zu senden, insbesondere automatisch.

Das Werkzeug kann einen Elektroantriebsmotor oder einen Verbrennungsantriebsmotor aufweisen beziehungsweise mittels eines Elektromotors oder eines Verbrennungsmotors angetrieben sein. Insbesondere kann der Elektromotor ein Universalmotor, oder ein bürstenbehafteter Gleichstrommotor, oder ein bürstenloser Gleichstrommotor, oder ein Drehstrommotor sein. Zusätzlich oder alternativ kann der sich ändernde magnetische Fluss durch ein Streufeld des Elektroantriebsmotors, einen Zündimpuls des Verbrennungsantriebsmotors, Stromänderungen, sich bewegende Magnete in einem Schwungrad des Werkzeugs, eines Generators, etc. verursacht sein oder werden. Insoweit sei auch auf die einschlägige Fachliteratur verwiesen.

Die Einrichtung kann zur, insbesondere mechanischen, Kopplung mit beziehungsweise Anbringung beziehungsweise Befestigung an, insbesondere in, dem Werkzeug ausgebildet sein. Insbesondere kann die Einrichtung zur, insbesondere lösbaren, Verbindung mit dem Werkzeug ausgebildet sein, insbesondere durch eine stoffschlüssige Verbindung wie eine Verklebung, eine kraftschlüssige Verbindung wie eine Rast- beziehungsweise Schnappverbindung und/oder ein formschlüssige Verbindung wie eine Verschraubung.

Zusätzlich oder alternativ kann die Einrichtung an, insbesondere in, dem Werkzeug angeordnet sein, insbesondere ein Teil des Werkzeugs sein. Alternativ kann die Einrichtung getrennt von dem Werkzeug ausgebildet sein. Dies ermöglicht eine Nachrüstung der Einrichtung an dem Werkzeug. Insbesondere kann die Einrichtung als Gerät bezeichnet werden. Weiter zusätzlich oder alternativ kann die Einrichtung bei Anordnung an dem Werkzeug in direktem Kontakt mit dem Werkzeug sein, insbesondere einem Werkzeuggehäuse beziehungsweise einer Haube des Werkzeugs.

Der induktive Sensor kann dazu ausgebildet sein, dass, unabhängig davon, ob das Werkzeug mittels eines Elektroantriebsmotors oder eines Verbrennungsantriebsmotors angetrieben sein kann, aufgrund des sich ändernden magnetischen Flusses in dem induktiven Sensor das Spannungssignal induziert werden kann. Somit kann der Ein-Zustand, insbesondere die, insbesondere von Null verschiedene, Drehzahl, für eine Vielzahl von Antriebstechnologien wie kabelgebunden, Akkumulator-basiert, verbrennungsmotorgetrieben mit derselben Einrichtung erfasst werden, insbesondere ohne dass eine leitungsgebundene Verbindung mit dem Werkzeug beziehungsweise mit Komponenten des Werkzeugs erforderlich sein braucht. Zusätzlich oder alternativ kann der induktive Sensor dazu ausgebildet sein, den sich ändernden magnetischen Fluss drahtlos zu erfassen beziehungsweise zu detektieren, insbesondere ohne eine galvanische Verbindung mit dem Werkzeug beziehungsweise Komponenten des Werkzeugs aufzuweisen. Weiter zusätzlich oder alternativ kann der induktive Sensor eine, insbesondere elektrische, Spule, insbesondere in Form einer bedrahteten Spule, einer Induktivität auf einem Chip und/oder einer SMD-Spule, aufweisen oder sein. Weiter zusätzlich oder alternativ kann das Spannungssignal als Selbstinduktionsspannungssignal bezeichnet werden. Insoweit sei auch auf die einschlägige Fachliteratur verwiesen.

Der induktive Sensor und der Kondensator können in Reihe geschaltet sein, insbesondere in Bezug auf einen Eingang des Verstärkers. Insbesondere können der Kondensator, der induktive Sensor und der Eingang, insbesondere in dieser Reihenfolge, in Reihe geschaltet sein.

Der Verstärker kann mit dem induktiven Sensor und/oder dem Kondensator elektrisch verbunden sein. Zusätzlich oder alternativ kann der Verstärker einen Operationsverstärker aufweisen oder sein. Insoweit sei auch auf die einschlägige Fachliteratur verwiesen.

Der erste Peak-Hold-Detektor und/oder der zweite Peak-Hold-Detektor können/kann, insbesondere jeweils, mit dem Verstärker, elektrisch verbunden sein. Zusätzlich oder alternativ können der erste Peak-Hold-Detektor und der zweite Peak-Hold-Detektor verschieden und/oder baugleich sein. Weiter zusätzlich oder alternativ können das obere Peaksignal und das untere Peaksignal verschieden sein. Insoweit sei auch auf die einschlägige Fachliteratur verwiesen. Die Auswerteeinrichtung kann mit dem ersten Peak-Hold-Detektor und/oder dem zweiten Peak-Hold-Detektor elektrisch verbunden sein. Zusätzlich oder alternativ ist die Differenzbildung softwareseitig Weiter zusätzlich oder alternativ kann der Schwellwert in mindestens drei insbesondere in mindestens fünf, insbesondere in mindestens zehn, insbesondere in mindestens zwanzig, insbesondere in mindestens fünfzig, insbesondere in mindestens hundert, verschiedenen Stufen oder kontinuierlich einstellbar sein. Weiter zusätzlich oder alternativ kann die Auswerteeinrichtung dazu ausgebildet sein, bei Erreichung oder Überschreitung des Schwellwerts zu bestimmen, dass der Zustand des Antriebsmotors Ein sein kann oder ist, insbesondere einen Wert beziehungsweise einen Betrag der, insbesondere von Null verschiedenen, Drehzahl zu bestimmen, und/oder bei Unterschreitung des Schwellwerts zu bestimmen, dass der Zustand des Antriebsmotors Aus sein kann oder ist. Weiter zusätzlich oder alternativ kann die Auswerteeinrichtung dazu ausgebildet sein, die Betriebsdaten, insbesondere in Form von Betriebsstunden beziehungsweise einer Betriebszeitdauer, insbesondere während welcher der Antriebsmotor Ein beziehungsweise aktiv sein kann, zu bestimmen beziehungsweise zu ermitteln. Weiter zusätzlich oder alternativ kann die Auswerteeinrichtung einen Mikrocontroller aufweisen oder sein. Insoweit sei auch auf die einschlägige Fachliteratur verwiesen.

Zusätzlich kann die Einrichtung einen, insbesondere elektrischen, Betriebsdatenspeicher aufweisen. Der Betriebsdatenspeicher kann dazu ausgebildet sein, den bestimmten Ein-Zustand, insbesondere die, insbesondere von Null verschiedene, Drehzahl, und/oder auf dem Ein-Zustand basierende Betriebsdaten zu speichern, insbesondere automatisch. Insbesondere kann der Betriebsdatenspeicher mit der Auswerteeinrichtung elektrisch verbunden sein. Zusätzlich oder alternativ kann der Betriebsdatenspeicher ein flüchtiger Speicher wie ein RAM (Random Access Memory) und/oder einen nicht-flüchtigen Speicher wie einen EEPROM-Speicher aufweisen oder sein. Insoweit sei auch auf die einschlägige Fachliteratur verwiesen.

Die Kommunikationsschnittstelle kann mit der Auswerteeinrichtung und/oder dem Betriebsdatenspeicher, soweit vorhanden, elektrisch verbunden sein. Insbesondere kann die Kommunikationsschnittstelle dazu ausgebildet sein, den gespeicherten Ein-Zustand, insbesondere die, insbesondere von Null verschiedene, Drehzahl, und/oder gespeicherte Betriebsdaten drahtlos zu dem Endgerät zu senden, insbesondere automatisch. Zusätzlich oder alternativ kann die Kommunikationsschnittstelle eine WLAN-Schnittstelle und/oder eine Bluetooth-Schnittstelle aufweisen oder sein. Weiter zusätzlich oder alternativ kann die Kommunikationsschnittstelle dazu ausgebildet sein, zu senden, unabhängig davon, ob sich ein Endgerät in Reichweite befindet oder nicht. Es kann ein festes oder ein veränderliches Zeitintervall zum Senden verwendet werden. Insoweit sei auch auf die einschlägige Fachliteratur verwiesen.

Die Einrichtung kann als elektrische Einrichtung bezeichnet werden. Zusätzlich oder alternativ kann die oben beschriebene Einrichtung mit allen ihren oder einem Teil ihrer Eigenschaften dazu vorgesehen sein, mit dem Werkzeug zur Erfassung des Ein-Zustands, insbesondere der, insbesondere von Null verschiedenen, Drehzahl, des Antriebsmotors des Werkzeugs verwendet werden zu können. In anderen Worten: Verwendung der Einrichtung zur Erfassung des Ein-Zustands, insbesondere der, insbesondere von Null verschiedenen, Drehzahl, des Antriebsmotors des Werkzeugs.

Das Endgerät kann beispielsweise basierend auf dem empfangenen Ein-Zustand, insbesondere der, insbesondere von Null verschiedenen, Drehzahl, und/oder den empfangenen Betriebsdaten Auswertungen vornehmen und diese beispielsweise einem Benutzer optisch aufbereitet darstellen.

Die Kommunikationsschnittstelle ist dazu ausgebildet, eine Einstellung des Schwellwerts drahtlos zu empfangen, insbesondere von einem, insbesondere, dem Endgerät, insbesondere automatisch. Dies ermöglicht eine relativ einfache und somit benutzerfreundliche Einstellung des Schwellwerts. Insbesondere kann die Kommunikationsschnittstelle dazu ausgebildet sein, die Differenz und/oder ein auf der Differenz basierendes Signal drahtlos zu einem, insbesondere dem, Endgerät zu senden. Das Endgerät kann dazu ausgebildet sein, basierend auf der empfangenen Differenz die Einstellung des Schwellwerts zu bestimmen beziehungsweise zu ermitteln und die bestimmte Einstellung des Schwellwerts zu senden. Zusätzlich oder alternativ kann die Kommunikationsschnittstelle dazu ausgebildet sein, die empfangene Einstellung des Schwellwerts an die Auswerteeinrichtung weiterzuleiten, insbesondere so dass die Auswerteeinrichtung die Einstellung des Schwellwerts als, insbesondere neuen, Schwellwert übernehmen kann. Weiter zusätzlich oder alternativ kann die Kommunikationsschnittstelle als bidirektionale Kommunikationsschnittstelle bezeichnet werden.

In einer Weiterbildung der Erfindung ist der Antriebsmotor ein Verbrennungsantriebsmotor. Der sich ändernde magnetische Fluss ist oder wird durch einen Zündimpuls des Verbrennungsantriebsmotors verursacht. Die Einrichtung beziehungsweise ihr Kondensator ermöglicht eine Erfassung des Zündimpulses. Insbesondere kann der Zündimpuls zeitlich relativ kurz und/oder relativ steil sein. Zusätzlich oder alternativ kann der Zündimpuls durch eine Zündkerze oder ein Zündkabel verursacht sein oder werden.

In einer Weiterbildung der Erfindung bilden der induktive Sensor und der Kondensator mindestens einen Teil eines, insbesondere elektrischen, Schwingkreises, insbesondere vollständig einen, insbesondere elektrischen, Schwingkreis. Dies ermöglicht, dass bei einem sich zeitlich relativ schnell ändernden magnetischen Fluss, insbesondere dem zeitlich relativ kurzen und/oder relativ steilen Zündimpuls, das induzierte Spannungssignal oder das auf dem Spannungssignal basierende Signal beziehungsweise ein Eingangssignal am Verstärker durch entstehende Oszillationen beziehungsweise Schwingungen künstlich verlangsamt beziehungsweise langsamer gedämpft werden kann oder wird. Somit kann das Ausgangsspannungssignal mehr Zeit über Schwellwerten der Peak-Hold-Detektoren zum Laden beziehungsweise Entladen von Samplekondensatoren der Peak-Hold-Detektoren verbringen. Somit kann die Differenz relativ groß sein. Somit kann der sich zeitlich relativ schnell ändernde magnetische Fluss, insbesondere der Zündimpuls, erfasst oder detektiert werden, der gemäß einem Verstärkungs-Bandbreite-Produkt des Verstärkers ohne Kondensator beziehungsweise Schwingkreis gar nicht messbar sein dürfte. Insbesondere kann der Verstärker mit dem Schwingkreis elektrisch verbunden sein.

In einer Weiterbildung der Erfindung weist der induktive Sensor eine, insbesondere elektrische, Induktivität von minimal 10 Mikrohenry (µH) und/oder von maximal 1000 Millihenry (mH) auf, insbesondere von 15 mH. Zusätzlich oder alternativ weist der Kondensator eine elektrische Kapazität von minimal 1 Pikofarad (pF) und/oder von maximal 1 Mikrofarad (µF) auf. Zusätzlich oder alternativ weist der elektrische Schwingkreis, soweit vorhanden, eine Resonanzfrequenz von minimal 50 Hertz (Hz) und/oder von maximal 5 Megahertz (MHz) auf. Zusätzlich oder alternativ weist der Verstärker ein Verstärkungs-Bandbreite-Produkt von minimal 100 Kilohertz (kHz) und/oder von maximal 5 Megahertz (MHz) auf. Insbesondere kann die Resonanzfrequenz von der Induktivität und der Kapazität abhängen.

In einer Weiterbildung der Erfindung weist die Einrichtung einen elektrischen Energiespeicher, insbesondere eine Batterie, auf. Der elektrischer Energiespeicher ist dazu ausgebildet, den induktiven Sensor, den Kondensator, den Verstärker, den ersten Peak-Hold-Detektor, den zweiten Peak-Hold-Detektor, die Auswerteeinrichtung und/oder die Kommunikationsschnittstelle mit elektrischer Energie beziehungsweise Spannung zu versorgen, insbesondere automatisch.

Der elektrische Energiespeicher ermöglicht, dass die Einrichtung ohne äußere Energieversorgung sein kann. Insbesondere kann die Batterie eine Knopfzelle, insbesondere eine CR 2032-Knopfzelle oder CR 2450-Knopfzelle, und/oder eine Lithium-Ionen-Batterie sein.

In einer Weiterbildung der Erfindung weist die Einrichtung mindestens einen elektrischen Widerstand auf. Der mindestens eine elektrische Widerstand ist mit dem induktiven Sensor und/oder einem, insbesondere dem, Eingang des Verstärkers derart elektrisch verbunden, dass der Eingang bei Nicht-Erfassung eines sich ändernden magnetischen Flusses beziehungsweise einer Erfassung keines sich ändernden magnetischen Flusses durch den induktiven Sensor beziehungsweise in Ruhe auf einem höheren Spannungspegel als 0 (Null) Volt (V) liegt, insbesondere bei Versorgung mit elektrischer Energie beziehungsweise Spannung, insbesondere automatisch. In anderen Worten: der elektrische Widerstand kann dazu ausgebildet sein, ein Spannungsoffset des induktiven Sensors beziehungsweise seines Spannungssignals zu generieren beziehungsweise zu erzeugen. Dies ermöglicht, dass sowohl eine positive Halbwelle als auch eine negative Halbwelle des induzierten Spannungssignals oder des auf dem Spannungssignal basierenden Signals genutzt werden können. Somit kann das Ausgangsspannungssignal sowohl eine positive Halbwelle als auch eine negative Halbwelle beziehungsweise die Halbwellen aufweisen. Insbesondere können der mindestens eine elektrische Widerstand und der induktive Sensor in Reihe geschaltet sein. Zusätzlich oder alternativ kann die Einrichtung zwei elektrische Widerstände aufweisen. Weiter zusätzlich oder alternativ können die 0 V als Bezugsspannung oder Ground bezeichnet werden.

In einer Ausgestaltung der Erfindung ist der Kondensator mit dem induktiven Sensor und/oder dem Eingang des Verstärkers derart elektrisch verbunden, dass der Kondensator den Eingang bei Erfassung des sich ändernden magnetischen Flusses durch den induktiven Sensor auf eine positive Spannung stützt, insbesondere bei Versorgung mit elektrischer Energie beziehungsweise Spannung, insbesondere automatisch. Dies ermöglicht, dass der Verstärker eine relativ kurze Erholungszeit haben kann und somit bei hohen Frequenzen ein relativ gutes Reaktionsvermögen aufweisen kann beziehungsweise performant sein kann.

In einer Weiterbildung der Erfindung weist die Auswerteeinrichtung einen, insbesondere elektrischen, Analog-Digital-Umsetzer auf. Der Analog-Digital-Umsetzer ist dazu ausgebildet, aus dem oberen Peaksignal und dem unteren Peaksignal die Differenz zu bilden, insbesondere zu digitalisieren, insbesondere automatisch. Insbesondere können/kann das obere Peaksignal und/oder das untere Peaksignal, insbesondere jeweils, analog sein. Zusätzlich oder alternativ kann die Differenz digital sein. Weiter zusätzlich oder alternativ kann der Analog-Digital-Umsetzer mit dem ersten Peak-Hold-Detektor und/oder dem zweiten Peak-Hold-Detektor elektrisch verbunden sein.

In einer Weiterbildung der Erfindung ist die Einrichtung dazu ausgebildet, den induktiven Sensor, den Kondensator, den Verstärker, den ersten Peak-Hold-Detektor und/oder den zweiten Peak-Hold-Detektor periodisch beziehungsweise zyklisch während einer Wachzeitdauer mit elektrischer Energie beziehungsweise Spannung, insbesondere von dem elektrischen Energiespeicher, soweit vorhanden, zu versorgen beziehungsweise zu aktivieren und während einer Schlafzeitdauer nicht mit elektrischer Energie zu versorgen beziehungsweise zu deaktivieren, insbesondere automatisch. Dies ermöglicht einen relativ niedrigen Energieverbrauch und somit eine relativ lange Laufzeit des elektrischen Energiespeichers, soweit vorhanden. Insbesondere kann die Einrichtung dazu ausgebildet sein, die Auswerteeinrichtung und/oder die Kommunikationsschnittstelle nicht während der Wachzeitdauer, sondern zeitlich danach mit elektrischer Energie zu versorgen beziehungsweise zu aktivieren, insbesondere periodisch. Insbesondere kann dann die Auswerteeinrichtung das obere Peaksignal, das von dem ersten Peak-Hold-Detektor gehalten werden kann oder wird, und das untere Peaksignal, das von dem zweiten Peak-Hold-Detektor gehalten werden kann oder wird, analysieren beziehungsweise auswerten, insbesondere die Differenz bilden, vergleichen und den Zustand, insbesondere die Drehzahl, bestimmen. Die Einrichtung kann dazu ausgebildet sein, die Auswerteeinrichtung und/oder die Kommunikationsschnittstelle zeitlich danach nicht mit elektrischer Energie zu versorgen beziehungsweise zu deaktivieren.

In einer Ausgestaltung der Erfindung ist die Wachzeitdauer minimal 10 Millisekunden (ms), insbesondere minimal 30 ms, und/oder maximal 1000 ms, insbesondere maximal 100 ms, insbesondere 40 ms. Zusätzlich oder alternativ ist die Schlafzeitdauer minimal 500 ms, insbesondere minimal 900 ms, und/oder maximal 600 Sekunden (s), insbesondere maximal 2 s, insbesondere 960 ms. Die derart dimensionierte Wachzeitdauer ermöglicht, mindestens einen Zündimpuls zu erfassen beziehungsweise zu detektieren.

In einer Weiterbildung der Erfindung ist die Einrichtung, insbesondere ihre Auswerteeinrichtung, dazu ausgebildet, den ersten Peak-Hold-Detektor und den zweiten Peak-Hold-Detektor zurückzusetzen, insbesondere in einen Anfangszustand, insbesondere zeitlich nach dem Bilden der Differenz, insbesondere automatisch. Dies ermöglicht den Ein-Zustand oder den Aus-Zustand, insbesondere die Drehzahl, des Antriebsmotors des Werkzeugs erneut beziehungsweise wiederholt beziehungsweise periodisch zu erfassen.

Das erfindungsgemäße System weist eine oben beschriebene Einrichtung und ein Werkzeug auf. Das Werkzeug weist einen Antriebsmotor auf. Insbesondere können/kann das Werkzeug und/oder sein Antriebsmotor teilweise oder ganz wie oben beschrieben ausgebildet sein.

In einer Weiterbildung der Erfindung ist das Werkzeug ein handgeführtes, insbesondere handgetragenes oder bodengeführtes, Werkzeug. Insbesondere handgeführtes, insbesondere handgetragenes, Werkzeug kann bedeuten, dass das Werkzeug eine Masse von maximal 50 Kilogramm (kg), insbesondere von maximal 20 kg, insbesondere von maximal 10 kg, aufweisen kann. Zusätzlich oder alternativ kann das Werkzeug ein Garten- und/oder Forstbearbeitungswerkzeug oder ein Bodenbearbeitungswerkzeug sein.

Insbesondere kann das Werkzeug eine Säge, oder ein Hoch-Entaster, oder eine Heckenschere, oder ein Heckenschneider, oder ein Laubbläser, oder ein Laubsauger, oder eine Kehrwalze, oder eine Kehrbürste, oder ein Rasenmäher, oder ein Freischneider, oder ein Vertikutierer, oder ein Trennschleifer, oder eine Motorhacke, oder ein Hochdruckreiniger, oder ein Spritzbeziehungsweise Sprühgerät, oder ein Bohrgerät sein.

Zusätzlich oder alternativ zu dem Werkzeug kann das erfindungsgemäße System ein Endgerät aufweisen. Insbesondere kann das Endgerät teilweise oder ganz wie oben beschrieben ausgebildet sein. Zusätzlich oder alternativ kann das Endgerät eine beliebige datenverarbeitende Einrichtung sein, die eine geeignete drahtlose Schnittstelle aufweisen kann, die zur drahtlosen Kommunikation mit der Kommunikationsschnittstelle der Einrichtung zur Erfassung des Ein-Zustands, insbesondere der, insbesondere von Null verschiedenen, Drehzahl, des Antriebsmotors ausgebildet sein kann. Weiter zusätzlich oder alternativ kann das Endgerät ein Gateway bilden beziehungsweise sein, das den empfangenen Ein-Zustand, insbesondere die, insbesondere von Null verschiedene, Drehzahl, oder die empfangenen Betriebsdaten an einen Server weiterleiten kann wie an einen sogenannten Cloud-Speicher, der den Ein-Zustand, insbesondere die, insbesondere von Null verschiedene, Drehzahl, oder die Betriebsdaten speichern kann. Der beziehungsweise die im Cloud-Speicher gespeicherte Ein-Zustand, insbesondere die, insbesondere von Null verschiedene, Drehzahl, oder gespeicherten Betriebsdaten können dann mittels eines geeigneten Tools wie eines Web-Browsers betrachtet und ausgewertet werden. Weiter zusätzlich oder alternativ kann das Endgerät ein mobiles Endgerät wie ein Laptop, ein Tablet oder ein Smartphone sein. Insbesondere mobil kann als portabel oder handgeführt, insbesondere handgetragen, bezeichnet werden.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind. Dabei zeigen:
- Fig. 1: ein schematisches Blockschaltbild eines erfindungsgemäßen Systems mit einer erfindungsgemäßen Einrichtung zur Erfassung eines Ein-Zustands eines Antriebsmotors eines Werkzeugs, dem Werkzeug und einem Endgerät,
- Fig. 2: ein detailliertes Blockschaltbild eines Ausschnitts der Einrichtung der Fig. 1,
- Fig. 3: einen Graph einer Differenz der Einrichtung der Fig. 1 mit einem Kondensator und ohne Kondensator über einer Frequenz eines sich ändernden magnetischen Flusses,
- Fig. 4: ein zeitliches Ablaufdiagramm zur Erfassung mittels der Einrichtung der Fig. 1,
- Fig. 5: eine schematische Explosionsansicht der Einrichtung der Fig. 1,
- Fig. 6: eine schematische Längsschnittansicht der Einrichtung der Fig. 1, und
- Fig. 7: eine schematische Perspektivansicht eines Ausschnitts des Werkzeugs der Fig. 1.

### DETAILLIERTE BESCHREIBUNG DER AUSFÜHRUNGSBEISPIELE

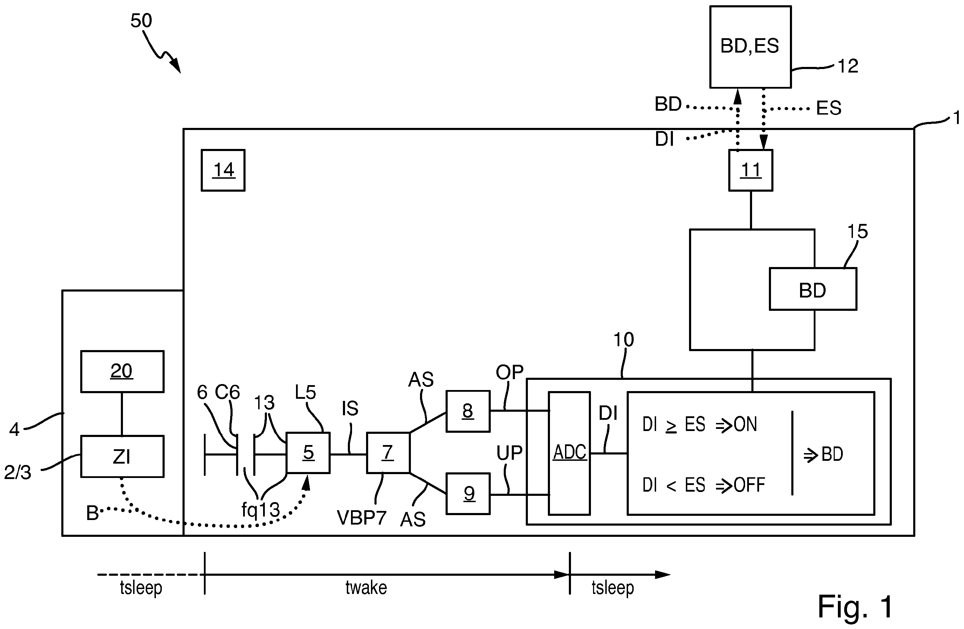

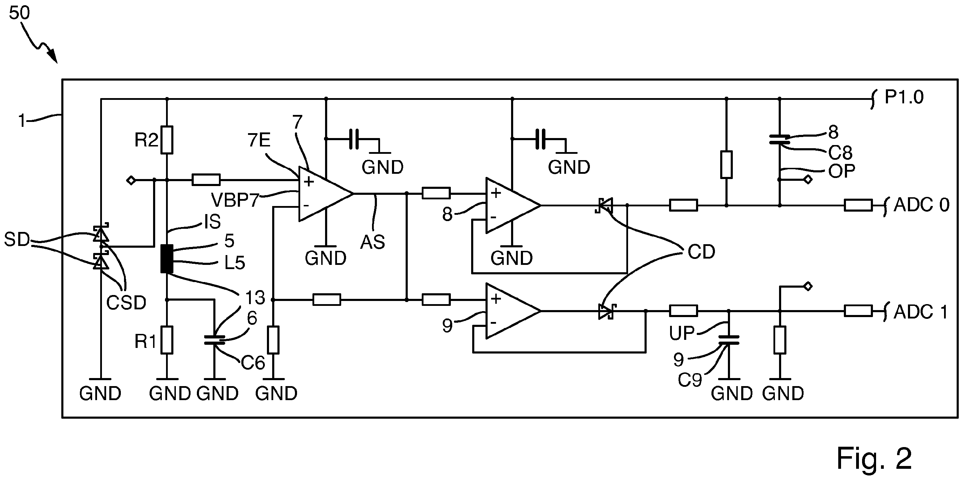

Fig. 1, 2 und 5 bis 7 zeigen ein erfindungsgemäßes System 50. Das System 50 weist eine Einrichtung 1, ein Werkzeug 4 und ein Endgerät 12 auf.

Im Detail weist das Werkzeug 4 einen Antriebsmotor 2, 3 auf, insbesondere einen Elektroantriebsmotor 3 oder einen Verbrennungsantriebsmotor 2, wie in Fig. 1 gezeigt.

Des Weiteren ist das Werkzeug 4 ein handgeführtes Werkzeug. Im gezeigten Ausführungsbeispiel ist das handgeführte Werkzeug 4 ein handgetragenes Werkzeug. In alternativen Ausführungsbeispielen kann das handgeführte Werkzeug ein bodengeführtes Werkzeug sein.

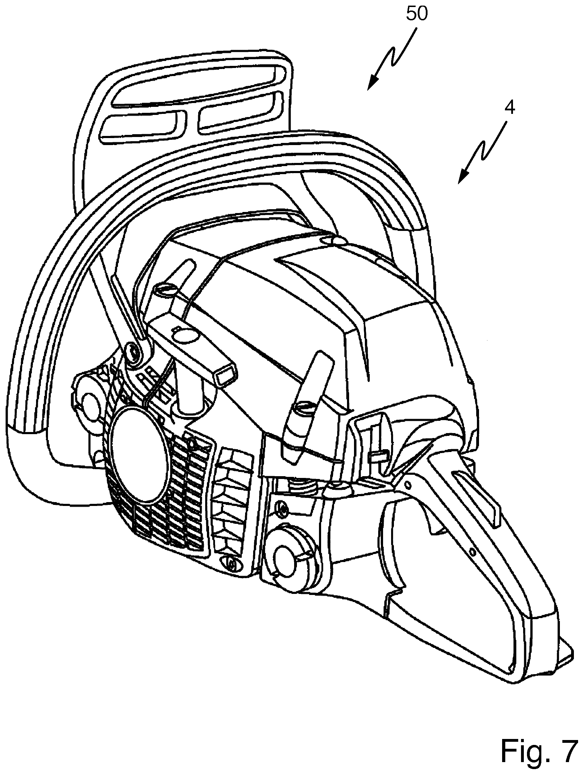

Im Detail ist das Werkzeug 4 eine Säge, wie in Fig. 7 gezeigt. Die Säge 4 weist eine Sägekette 20 auf, wobei insbesondere der Elektroantriebsmotor 3 oder der Verbrennungsantriebsmotor 2 zum Antrieb der Sägekette 20 ausgebildet ist. In alternativen Ausführungsbeispielen kann das Werkzeug ein Hoch-Entaster, oder eine Heckenschere, oder ein Heckenschneider, oder ein Laubbläser, oder ein Laubsauger, oder eine Kehrwalze, oder eine Kehrbürste, oder ein Rasenmäher, oder ein Freischneider, oder ein Vertikutierer, oder ein Trennschleifer, oder eine Motorhacke, oder ein Hochdruckreiniger, oder ein Spritz- beziehungsweise Sprühgerät, oder ein Bohrgerät sein.

Die erfindungsgemäße Einrichtung 1 ist zur Erfassung eines Ein-Zustands On des Antriebsmotors 2, 3 des Werkzeugs 4 ausgebildet. Des Weiteren ist die Einrichtung 1 zur Anordnung an dem Werkzeug 4 ausgebildet beziehungsweise im gezeigten Ausführungsbeispiel an dem Werkzeug 4 angeordnet. Im Ein-Zustand On des Antriebsmotors 2, 3 wird ein sich ändernder magnetischer Fluss B bewirkt. Außerdem weist die Einrichtung 1 einen induktiven Sensor 5, einen Kondensator 6, einen Verstärker 7, einen ersten Peak-Hold-Detektor 8, einen zweiten Peak-Hold-Detektor 9, eine Auswerteeinrichtung 10 und eine Kommunikationsschnittstelle 11 auf, wie in Fig. 1, 2, 5 und 6 gezeigt. Der induktive Sensor 5 in Form einer Spule ist dazu ausgebildet, dass aufgrund des sich ändernden magnetischen Flusses B in dem induktiven Sensor 5 ein Spannungssignal IS induziert wird. Der Kondensator 6 ist elektrisch mit dem induktiven Sensor 5 verbunden. Im gezeigten Ausführungsbeispiel ist der Verstärker 7 in Form eines Operationsverstärkers dazu ausgebildet, das induzierte Spannungssignal IS in ein Ausgangsspannungssignal AS zu verstärken. In alternativen Ausführungsbeispielen kann der Verstärker dazu ausgebildet sein, ein auf dem Spannungssignal basierendes Signal in ein Ausgangsspannungssignal zu verstärken. Im gezeigten Ausführungsbeispiel ist der erste Peak-Hold-Detektor 8 dazu ausgebildet, aus dem Ausgangsspannungssignal AS ein oberes Peaksignal OP zu erzeugen. In alternativen Ausführungsbeispielen kann der erste Peak-Hold-Detektor dazu ausgebildet sein, aus einem auf dem Ausgangsspannungssignal basierenden Signal ein oberes Peaksignal zu erzeugen. Im gezeigten Ausführungsbeispiel ist der zweite Peak-Hold-Detektor 9 dazu ausgebildet, aus dem Ausgangsspannungssignal AS ein unteres Peaksignal UP zu erzeugen. In alternativen Ausführungsbeispielen kann der zweite Peak-Hold-Detektor dazu ausgebildet sein, aus dem auf dem Ausgangsspannungssignal basierenden Signal ein unteres Peaksignal zu erzeugen. Die Auswerteeinrichtung 10 ist dazu ausgebildet, aus dem erzeugten oberen Peaksignal OP und dem erzeugten unteren Peaksignal UP eine Differenz DI zu bilden. Des Weiteren ist im gezeigten Ausführungsbeispiel die Auswerteeinrichtung 10 in Form eines Mikrocontrollers dazu ausgebildet, die gebildete Differenz DI mit einem einstellbaren Schwellwert ES zu vergleichen. In alternativen Ausführungsbeispielen kann die Auswerteeinrichtung dazu ausgebildet sein, eine auf der gebildeten Differenz basierende Größe mit einem einstellbaren Schwellwert zu vergleichen. Außerdem ist die Auswerteeinrichtung 10 dazu ausgebildet, bei Erreichung oder Überschreitung des Schwellwerts ES den Ein-Zustand On des Antriebsmotors 2, 3 zu bestimmen. Im gezeigten Ausführungsbeispiel ist die Kommunikationsschnittstelle 11 dazu ausgebildet, auf dem Ein-Zustand On basierende Betriebsdaten BD drahtlos zu einem Endgerät 12 zu senden. In alternativen Ausführungsbeispielen kann die Kommunikationsschnittstelle dazu ausgebildet sein, den bestimmten Ein-Zustand drahtlos zu dem Endgerät zu senden.

Zusätzlich ist die Einrichtung 1 zur Erfassung eines Aus-Zustands Off des Antriebsmotors 2, 3 des Werkzeugs 4 ausgebildet. Im Detail wird im Aus-Zustand Off des Antriebsmotors 2, 3 kein sich ändernder magnetischer Fluss bewirkt und im induktiven Sensor 5 wird kein Spannungssignal induziert. Die Auswerteeinrichtung 10 ist dazu ausgebildet, bei Unterschreitung des Schwellwerts ES den Aus-Zustand Off des Antriebsmotors 2, 3 zu bestimmen. Die Kommunikationsschnittstelle 11 ist dazu ausgebildet, die auf dem Aus-Zustand Off basierende Betriebsdaten BD drahtlos zu dem Endgerät 12 zu senden.

Insbesondere ist zur Erfassung des sich ändernden magnetischen Flusses eine Flussrichtung in Bezug auf den induktiven Sensor 5 zu berücksichtigen. Der induktive Sensor 5 kann mehrere einzelne Teilspulen aufweisen, die zueinander verschieden ausgerichtet sein können. Weiter kann eine definierte Positionierung des induktiven Sensors 5 an dem Werkzeug 4 beziehungsweise eine definierte Ausrichtung des induktiven Sensors 5 in Bezug auf das Werkzeug 4 gewählt werden.

Im Detail ist der sich ändernde magnetische Fluss B durch einen Zündimpuls ZI des Verbrennungsantriebsmotors 2 verursacht.

Weiter bilden der induktive Sensor 5 und der Kondensator 6 mindestens einen Teil eines Schwingkreises 13.

Im Detail weist die Einrichtung 1 Schutzdioden SD mit parasitären Kapazitäten CSD auf. Der induktive Sensor 5, der Kondensator 6 und die Schutzdioden SD bilden vollständig den Schwingkreis 13.

Im gezeigten Ausführungsbeispiel weist der induktive Sensor 5 eine Induktivität L5 von 15 mH auf. In alternativen Ausführungsbeispielen kann der induktive Sensor eine Induktivität von minimal 10 µH und/oder von maximal 1000 mH aufweisen.

Des Weiteren weist im gezeigten Ausführungsbeispiel der Kondensator 6 eine elektrische Kapazität C6 von minimal 1 pF und/oder von maximal 1 µF auf.

Außerdem weist im gezeigten Ausführungsbeispiel der elektrische Schwingkreis 13 eine Resonanzfrequenz fq13 von minimal 50 Hz und/oder von maximal 5 MHz auf.

Weiter weist im gezeigten Ausführungsbeispiel der Verstärker 7 ein Verstärkungs-Bandbreite-Produkt VBP7 von minimal 100 kHz und/oder von maximal 5 MHz auf.

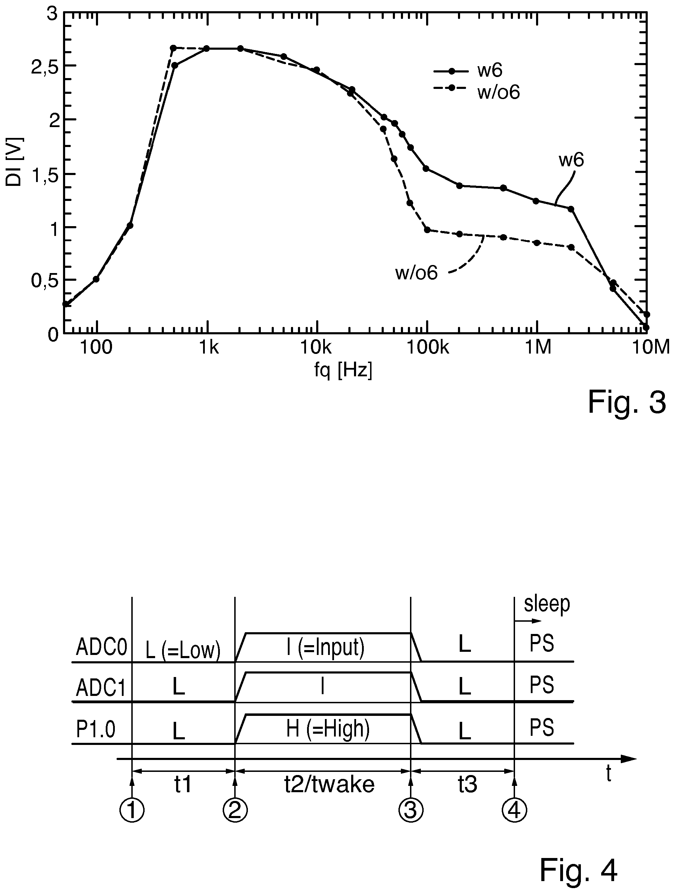

Der Kondensator 6 stimmt den Schwingkreis 13 ab und verbessert somit die Differenz DI bei hohen Frequenzen fq ab 100 kHz deutlich, wie in Fig. 3 für eine Anregung der Einrichtung 1 mit einem Einzelpuls für verschiedene Frequenzen fq mit und ohne Kondensator 6 gezeigt.

Im Detail ermöglicht der Schwingkreis 13 beziehungsweise der Kondensator 6, dass bei einem sich zeitlich relativ schnell ändernden magnetischen Fluss B, insbesondere dem zeitlich relativ kurzen und/oder relativ steilen Zündimpuls ZI, das induzierte Spannungssignal IS am Verstärker 7 durch entstehende Oszillationen künstlich verlangsamt beziehungsweise langsamer gedämpft wird. Somit verbringt das Ausgangsspannungssignal AS mehr Zeit über Schwellwerten der Peak-Hold-Detektoren 8, 9 zum Laden beziehungsweise Entladen von Samplekondensatoren C8, C9 der Peak-Hold-Detektoren 8, 9. Somit ist die Differenz DI relativ groß.

Des Weiteren verstärkt im gezeigten Ausführungsbeispiel der Verstärker 7 das induzierte Spannungssignal IS um einen Faktor 100.

Zusätzlich weist die Einrichtung 1 einen elektrischen Energiespeicher 14, insbesondere eine Batterie in Form einer Knopfzelle, auf. Der elektrischer Energiespeicher 14 ist dazu ausgebildet, den induktiven Sensor 5, den Kondensator 6, den Verstärker 7, den ersten Peak-Hold-Detektor 8, den zweiten Peak-Hold-Detektor 9, die Auswerteeinrichtung 10 und/oder die Kommunikationsschnittstelle 11 mit elektrischer Energie zu versorgen, insbesondere mit einer Spannung beispielsweise von 3 V.

Weiter zusätzlich weist die Einrichtung 1 mindestens einen elektrischen Widerstand R1, R2 auf. Der mindestens eine elektrische Widerstand R1, R2 ist mit dem induktiven Sensor 5 und einem Eingang 7E des Verstärkers 7 derart elektrisch verbunden, dass der Eingang 7E bei Nicht-Erfassung eines sich ändernden magnetischen Flusses durch den induktiven Sensor 5 auf einem höheren Spannungspegel als 0 V liegt, beispielsweise auf 1,5 V, insbesondere bei Versorgung mit elektrischer Energie beziehungsweise Spannung.

Im gezeigten Ausführungsbeispiel weist die Einrichtung einen ersten elektrischen Widerstand R1 und einen zweiten elektrischen Widerstand R2 auf.

Zudem ist der Kondensator 6 mit dem induktiven Sensor 5 und dem Eingang 7E des Verstärkers 7 derart elektrisch verbunden, dass der Kondensator 6 den Eingang 7E bei Erfassung des sich ändernden magnetischen Flusses B durch den induktiven Sensor 5 auf eine positive Spannung stützt, insbesondere bei Versorgung mit elektrischer Energie beziehungsweise Spannung.

Im Detail weist die Einrichtung 1 eine Bezugsspannung von 0 V beziehungsweise Ground GND auf.

Ground GND, der Kondensator 6, der induktive Sensor 5 und der Eingang 7E des Verstärkers 7 sind in dieser Reihenfolge in Reihe geschaltet.

Des Weiteren weist die Einrichtung 1 beziehungsweise ihre Auswerteeinrichtung 10 einen Pin beziehungsweise einen Port P1.0 auf. Die Einrichtung 1 beziehungsweise ihre Auswerteeinrichtung 10 ist dazu ausgebildet, den Pin P1.0 entweder als Ausgang oder in einen Energiesparzustand PS zu konfigurieren und/oder entweder auf Low beziehungsweise 0 V beziehungsweise GND oder auf High beziehungsweise die Spannung des elektrischen Energiespeichers 14, beispielsweise 3 V, zu setzen.

Ground GND, der erste elektrische Widerstand R1, der induktive Sensor 5, der zweite elektrische Widerstand R2 und der Pin P1.0 sind in dieser Reihenfolge in Reihe geschaltet.

Somit kann der induktive Sensor 5 auf einem höheren Spannungspergel als 0 V liegen.

Im Detail sind der Kondensator 6 und der erste elektrische Widerstand R1 zwischen Ground GND und dem induktiven Sensor 5 parallel geschaltet.

Außerdem weist die Auswerteeinrichtung einen Analog-Digital-Umsetzer ADC auf. Der Analog-Digital-Umsetzer ADC ist dazu ausgebildet, aus dem oberen Peaksignal OP und dem unteren Peaksignal UP die Differenz DI zu bilden.

Im Detail weist der Analog-Digital-Umsetzer ADC einen ersten Pin beziehungsweise einen ersten Port ADCO auf. Weiter weist der Analog-Digital-Umsetzer ADC einen zweiten Pin beziehungsweise einen zweiten Port ADC1 auf. Die Einrichtung 1 beziehungsweise ihre Auswerteeinrichtung 10 beziehungsweise ihr Analog-Digital-Umsetzer ADC ist dazu ausgebildet, den ersten Pin ADCO und/oder den zweiten Pin ADC1, insbesondere jeweils, entweder als Ausgang oder als Eingang oder in einen Energiesparzustand PS zu konfigurieren und/oder entweder auf Low beziehungsweise 0 V beziehungsweise GND oder auf High beziehungsweise die Spannung des elektrischen Energiespeichers 14, beispielsweise 3 V, zu setzen. Der erste Pin ADCO ist mit dem ersten Peak-Hold-Detektor 8 elektrisch verbunden. Der zweite Pin ADC1 ist mit dem zweiten Peak-Hold-Detektor 9 elektrisch verbunden.

Zudem ist der erste Peak-Hold-Detektor 8 mit dem Verstärker 7 elektrisch verbunden und der zweite Peak-Hold-Detektor 9 ist mit dem Verstärker 7 elektrisch verbunden.

Im Detail weist der erste Peak-Hold-Detektor 8 einen ersten Samplekondensator C8 auf. Der zweite Peak-Hold-Detektor 9 weist einen zweiten Samplekondensator C9 auf.

Des Weiteren ist die Einrichtung 1 dazu ausgebildet, den induktiven Sensor 5, den Kondensator 6, den Verstärker 7, den ersten Peak-Hold-Detektor 8 und/oder den zweiten Peak-Hold-Detektor 9 periodisch während einer Wachzeitdauer twake mit elektrischer Energie beziehungsweise Spannung, insbesondere von dem elektrischen Energiespeicher 14, zu versorgen und während einer Schlafzeitdauer tsleep nicht mit elektrischer Energie zu versorgen.

Im gezeigten Ausführungsbeispiel ist die Wachzeitdauer twake 40 ms. In alternativen Ausführungsbeispielen kann die Wachzeitdauer minimal 10 ms und/oder maximal 1000 ms sein.

Außerdem ist im gezeigten Ausführungsbeispiel die Schlafzeitdauer tsleep 960 ms. In alternativen Ausführungsbeispielen kann die Schlafzeitdauer minimal 500 ms und/oder maximal 600 s sein.

Weiter ist die Einrichtung 1 beziehungsweise ihre Auswerteeinrichtung 10 beziehungsweise ihr Analog-Digital-Umsetzer ADC dazu ausgebildet, den ersten Peak-Hold-Detektor 8 und den zweiten Peak-Hold-Detektor 9 zurückzusetzen, insbesondere in einen Anfangszustand, insbesondere zeitlich nach dem Bilden der Differenz DI.

Im Detail wird zur Erfassung erstens beziehungsweise zeitlich zuerst der Pin P1.0 als Ausgang konfiguriert und auf Low gesetzt, wie in Fig. 4 gezeigt. Der erste Pin ADCO und der zweite Pin ADC1 werden, insbesondere jeweils, als Ausgang konfiguriert. Der erste Pin ADCO wird auf Low gesetzt. Der zweite Pin ADC1 wird auf Low gesetzt. Somit werden der erste Peak-Hold-Detektor 8 beziehungsweise sein erster Samplekondensator C8 und der zweite Peak-Hold-Detektor 9 beziehungsweise sein zweiter Samplekondensator C9, insbesondere jeweils, entladen.

Zweitens beziehungsweise zeitlich danach werden der erste Pin ADCO und der zweite Pin ADC1, insbesondere jeweils, als Eingang konfiguriert. Somit wird ein Erfassungszeitfenster geöffnet. Der Pin P1.0 wird auf High gesetzt, insbesondere für die Wachzeitdauer twake. Somit werden der induktive Sensor 5, der Kondensator 6, der Verstärker 7, der erste Peak-Hold-Detektor 8 und/oder der zweite Peak-Hold-Detektor 9 mit elektrischer Energie versorgt.

Drittens beziehungsweise zeitlich danach bildet der Analog-Digital-Umsetzer ADC aus dem oberen Peaksignal OP und dem unteren Peaksignal UP die Differenz DI. Der erste Pin ADCO wird als Ausgang konfiguriert und auf Low gesetzt. Der Pin P1.0 wird auf Low gesetzt. Der zweite Pin ADC1 wird als Ausgang konfiguriert und auf Low gesetzt. Somit werden der erste Peak-Hold-Detektor 8 beziehungsweise sein erster Samplekondensator C8 und der zweite Peak-Hold-Detektor 9 beziehungsweise sein zweiter Samplekondensator C9, insbesondere jeweils, entladen. Dies ermöglicht einen Strom über Klemmdioden CD der Peak-Hold-Detektoren 8, 9 zu verhindern.

Viertens beziehungsweise zeitlich danach werden der erste Pin ADCO und der zweite Pin ADC1, insbesondere jeweils, in den Energiesparzustand PS konfiguriert. Der Pin P1.0 wird in den Energiesparzustand PS konfiguriert. Somit werden der induktive Sensor 5, der Kondensator 6, der Verstärker 7, der erste Peak-Hold-Detektor 8 und/oder der zweite Peak-Hold-Detektor 9 nicht mit elektrischer Energie versorgt.

Somit setzt die Einrichtung 1 beziehungsweise ihre Auswerteeinrichtung 10 beziehungsweise ihr Analog-Digital-Umsetzer ADC den ersten Peak-Hold-Detektor 8 und den zweiten Peak-Hold-Detektor 9 zurück.

Bei Erreichung oder Überschreitung des Schwellwerts ES durch die Differenz DI bestimmt die Auswerteeinrichtung 10, dass der Zustand des Antriebsmotors 2,3 Ein ist. Bei Unterschreitung des Schwellwerts ES durch die Differenz bestimmt die Auswerteeinrichtung 10, dass der Zustand des Antriebsmotors 2,3 Aus ist.

Im gezeigten Ausführungsbeispiel ist die Auswerteeinrichtung 10 dazu ausgebildet, die Betriebsdaten BD, insbesondere in Form von Betriebsstunden, insbesondere während welcher der Antriebsmotor Ein beziehungsweise aktiv ist, zu bestimmen.

Des Weiteren ist die Kommunikationsschnittstelle 11 mit der Auswerteeinrichtung 10 elektrisch verbunden.

Außerdem ist die Kommunikationsschnittstelle 11 dazu ausgebildet, eine Einstellung des Schwellwerts ES drahtlos zu empfangen.

Im Detail ist die Kommunikationsschnittstelle 11 dazu ausgebildet, die Differenz DI und/oder ein auf der Differenz basierendes Signal drahtlos zu dem Endgerät 12 zu senden. Das Endgerät 12 ist dazu ausgebildet, basierend auf der empfangenen Differenz DI die Einstellung des Schwellwerts ES zu bestimmen und die bestimmte Einstellung des Schwellwerts ES zu senden.

Weiter weist die Einrichtung 1 einen Betriebsdatenspeicher 15 auf. Der Betriebsdatenspeicher 15 ist dazu ausgebildet, die Betriebsdaten BD zu speichern.

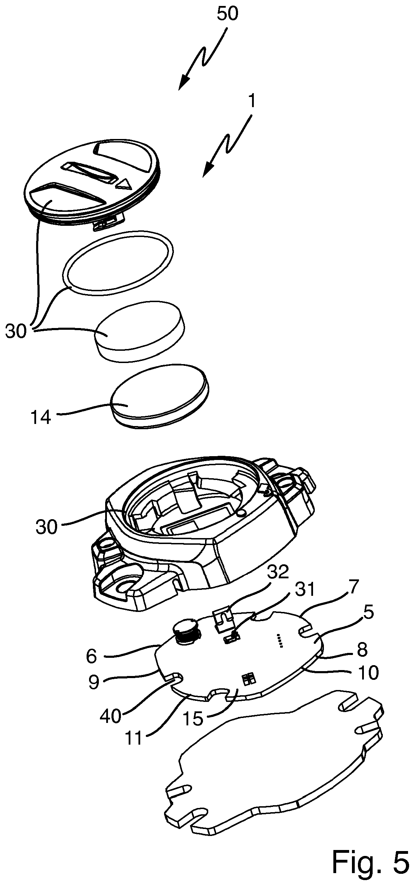

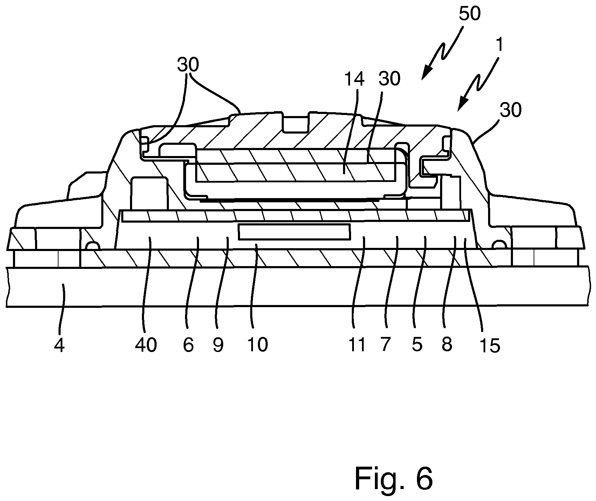

Zudem ist die Einrichtung 1 getrennt von dem Werkzeug 4 ausgebildet, wie in Fig. 5 und 6 gezeigt.

Des Weiteren weist die Einrichtung 1 ein Gehäuse 30 auf. Das Gehäuse 30 ist zur Aufnahme des elektrischen Energiespeichers 14 ausgebildet.

Außerdem weist die Einrichtung 1 federnde elektrische Kontaktelemente 31, 32 auf, im gezeigten Ausführungsbeispiel zwei. Die federnden elektrischen Kontaktelemente 31, 32 sind dazu ausgebildet, korrespondierende elektrische Kontakte des aufgenommenen elektrischen Energiespeichers 14 elektrisch zu kontaktieren.

Weiter sind die Kontaktelemente 31, 32 aus dem Gehäuse 30 nach außen herausgeführt und dort elektrisch mit korrespondierenden Anschlüssen, insbesondere auf einer Platine 40 der Einrichtung 1, verbunden.

Im Detail ist die Platine 40 an einer Unterseite des Gehäuses 30 angeordnet. Insbesondere ist die Platine 40 mit dem Gehäuse 30 mechanisch verbunden.

Im gezeigten Ausführungsbeispiel weist die Platine 40 den induktiven Sensor 5, den Kondensator 6, den Verstärker 7, den ersten Peak-Hold-Detektor 8, den zweiten Peak-Hold-Detektor 9, die Auswerteeinrichtung 10, die Kommunikationsschnittstelle 11 und den Betriebsdatenspeicher 15 auf.

Wie die gezeigten und oben erläuterten Ausführungsbeispiele deutlich machen, stellt die Erfindung eine Einrichtung zur Erfassung eines Ein-Zustands eines Antriebsmotors eines Werkzeugs, die gut erfasst und energiesparend und flexibel ist, und ein System mit einer solchen Einrichtung und einem Werkzeug aufweisend einen Antriebsmotor und/oder einem Endgerät bereit.

## Patentansprüche

1. Einrichtung (1) zur Erfassung eines Ein-Zustands (On) eines Antriebsmotors (2, 3) eines Werkzeugs (4), wobei die Einrichtung (1) zur Anordnung an dem Werkzeug (4) ausgebildet ist, wobei im Ein-Zustand (On) des Antriebsmotors (2, 3) ein sich ändernder magnetischer Fluss (B) bewirkt wird, wobei die Einrichtung (1) aufweist:
- einen induktiven Sensor (5), wobei der induktive Sensor (5) dazu ausgebildet ist, dass aufgrund des sich ändernden magnetischen Flusses (B) in dem induktiven Sensor (5) ein Spannungssignal (IS) induziert wird,
- einen Kondensator (6), wobei der Kondensator (6) elektrisch mit dem induktiven Sensor (5) verbunden ist,
- einen Verstärker (7), wobei der Verstärker (7) dazu ausgebildet ist, das induzierte Spannungssignal (IS) oder ein auf dem Spannungssignal basierendes Signal in ein Ausgangsspannungssignal (AS) zu verstärken,
- einen ersten Peak-Hold-Detektor (8) und einen zweiten Peak-Hold-Detektor (9), wobei der erste Peak-Hold-Detektor (8) dazu ausgebildet ist, aus dem Ausgangsspannungssignal (AS) oder einem auf dem Ausgangsspannungssignal basierenden Signal ein oberes Peaksignal (OP) zu erzeugen, und wobei der zweite Peak-Hold-Detektor (9) dazu ausgebildet ist, aus dem Ausgangsspannungssignal (AS) oder dem auf dem Ausgangsspannungssignal basierenden Signal ein unteres Peaksignal (UP) zu erzeugen,
- eine Auswerteeinrichtung (10), wobei die Auswerteeinrichtung (10) dazu ausgebildet ist, aus dem erzeugten oberen Peaksignal (OP) und dem erzeugten unteren Peaksignal (UP) eine Differenz (DI) zu bilden, die gebildete Differenz (DI) oder eine auf der gebildeten Differenz basierende Größe mit einem einstellbaren Schwellwert (ES) zu vergleichen, wobei der Schwellwert (ES) softwareseitig ist, und bei Erreichung oder Überschreitung des Schwellwerts (ES) den Ein-Zustand (On) des Antriebsmotors (2, 3) zu bestimmen, und
- eine Kommunikationsschnittstelle (11), wobei die Kommunikationsschnittstelle (11) dazu ausgebildet ist, den bestimmten Ein-Zustand und/oder auf dem Ein-Zustand (On) basierende Betriebsdaten (BD) drahtlos zu einem Endgerät (12) zu senden, und wobei die Kommunikationsschnittstelle (11) dazu ausgebildet ist, eine Einstellung des Schwellwerts (ES) drahtlos zu empfangen.

2. Einrichtung (1) nach Anspruch 1,
- wobei der Antriebsmotor (2) ein Verbrennungsantriebsmotor ist und wobei der sich ändernde magnetische Fluss (B) durch einen Zündimpuls (ZI) des Verbrennungsantriebsmotors (2) verursacht ist.

3. Einrichtung (1) nach einem der vorhergehenden Ansprüche,
- wobei der induktive Sensor (5) und der Kondensator (6) mindestens einen Teil eines Schwingkreises (13) bilden.

4. Einrichtung (1) nach einem der vorhergehenden Ansprüche,
- wobei der induktive Sensor (5) eine Induktivität (L5) von minimal 10 µH und/oder von maximal 1000 mH aufweist, und/oder
- wobei der Kondensator (6) eine elektrische Kapazität (C6) von minimal 1 pF und/oder von maximal 1 µF aufweist, und/oder
- wobei der elektrische Schwingkreis (13) eine Resonanzfrequenz (fq13) von minimal 50 Hz und/oder von maximal 5 MHz aufweist, und/oder
- wobei der Verstärker (7) ein Verstärkungs-Bandbreite-Produkt (VBP7) von minimal 100 kHz und/oder von maximal 5 MHz aufweist.

5. Einrichtung (1) nach einem der vorhergehenden Ansprüche,
- wobei die Einrichtung (1) einen elektrischen Energiespeicher (14), insbesondere eine Batterie, aufweist, wobei der elektrischer Energiespeicher (14) dazu ausgebildet ist, den induktiven Sensor (5), den Kondensator (6), den Verstärker (7), den ersten Peak-Hold-Detektor (8), den zweiten Peak-Hold-Detektor (9), die Auswerteeinrichtung (10) und/oder die Kommunikationsschnittstelle (11) mit elektrischer Energie zu versorgen.

6. Einrichtung (1) nach einem der vorhergehenden Ansprüche,
- wobei die Einrichtung (1) mindestens einen elektrischen Widerstand (R1, R2) aufweist, wobei der mindestens eine elektrische Widerstand (R1, R2) mit dem induktiven Sensor (5) und/oder einem Eingang (7E) des Verstärkers (7) derart elektrisch verbunden ist, dass der Eingang (7E) bei Nicht-Erfassung eines sich ändernden magnetischen Flusses durch den induktiven Sensor (5) auf einem höheren Spannungspegel als 0 V liegt.

7. Einrichtung (1) nach Anspruch 6,
- wobei der Kondensator (6) mit dem induktiven Sensor (5) und/oder dem Eingang (7E) des Verstärkers (7) derart elektrisch verbunden ist, dass der Kondensator (6) den Eingang (7E) bei Erfassung des sich ändernden magnetischen Flusses (B) durch den induktiven Sensor (5) auf eine positive Spannung stützt.

8. Einrichtung (1) nach einem der vorhergehenden Ansprüche,
- wobei die Auswerteeinrichtung (10) einen Analog-Digital-Umsetzer (ADC) aufweist, wobei der Analog-Digital-Umsetzer (ADC) dazu ausgebildet ist, aus dem oberen Peaksignal (OP) und dem unteren Peaksignal (UP) die Differenz (DI) zu bilden.

9. Einrichtung (1) nach einem der vorhergehenden Ansprüche,
- wobei die Einrichtung (1) dazu ausgebildet ist, den induktiven Sensor (5), den Kondensator (6), den Verstärker (7), den ersten Peak-Hold-Detektor (8) und/oder den zweiten Peak-Hold-Detektor (9) periodisch während einer Wachzeitdauer (twake) mit elektrischer Energie zu versorgen und während einer Schlafzeitdauer (tsleep) nicht mit elektrischer Energie zu versorgen.

10. Einrichtung (1) nach Anspruch 9,
- wobei die Wachzeitdauer (twake) minimal 10 ms und/oder maximal 1000 ms ist, und/oder
- wobei die Schlafzeitdauer (tsleep) minimal 500 ms und/oder maximal 600 s ist.

11. Einrichtung (1) nach einem der vorhergehenden Ansprüche,
- wobei die Einrichtung (1) dazu ausgebildet ist, den ersten Peak-Hold-Detektor (8) und den zweiten Peak-Hold-Detektor (9) zurückzusetzen.

12. System (50), wobei das System (50) aufweist:
- eine Einrichtung (1) nach einem der vorhergehenden Ansprüche, und
- ein Werkzeug (4), wobei das Werkzeug (4) einen Antriebsmotor (2, 3) aufweist.

13. System (50) nach Anspruch 12,
- wobei das Werkzeug (4) ein handgeführtes, insbesondere handgetragenes oder bodengeführtes, Werkzeug ist.

14. System (50), wobei das System (50) aufweist:
- eine Einrichtung (1) nach einem der vorhergehenden Ansprüche, und
- ein Endgerät (12).

## Claims

1. Device (1) for registering an On state (On) of a drive motor (2, 3) of a tool (4), wherein the device (1) is designed for arrangement on the tool (4), wherein a changing magnetic flux (B) is produced in the On state (On) of the drive motor (2, 3), wherein the device (1) has:
- an inductive sensor (5), wherein the inductive sensor (5) is designed so that a voltage signal (IS) is induced in the inductive sensor (5) on the basis of the changing magnetic flux (B),
- a capacitor (6), wherein the capacitor (6) is electrically connected to the inductive sensor (5),
- an amplifier (7), wherein the amplifier (7) is designed to amplify the induced voltage signal (IS) or a signal based on the voltage signal to produce an output voltage signal (AS),
- a first peak hold detector (8) and a second peak hold detector (9), wherein the first peak hold detector (8) is designed to generate an upper peak signal (OP) from the output voltage signal (AS) or a signal based on the output voltage signal, and wherein the second peak hold detector (9) is designed to generate a lower peak signal (UP) from the output voltage signal (AS) or the signal based on the output voltage signal,
- an evaluation device (10), wherein the evaluation device (10) is designed to form a difference (DI) from the generated upper peak signal (OP) and the generated lower peak signal (UP), to compare the formed difference (DI) or a quantity based on the formed difference with an adjustable threshold value (ES), wherein the threshold value (ES) is software-based, and to determine the On state (On) of the drive motor (2, 3) when the threshold value (ES) is reached or exceeded, and
- a communication interface (11), wherein the communication interface (11) is designed to send the determined On state and/or operating data (BD) based on the On state (On) wirelessly to a terminal (12), and wherein the communication interface (11) is designed to receive a setting for the threshold value (ES) wirelessly.

2. Device (1) according to Claim 1,
- wherein the drive motor (2) is an internal combustion drive engine and wherein the changing magnetic flux (B) is caused by an ignition pulse (ZI) of the internal combustion drive engine (2).

3. Device (1) according to either of the preceding claims,
- wherein the inductive sensor (5) and the capacitor (6) form at least part of a resonant circuit (13).

4. Device (1) according to one of the preceding claims,
- wherein the inductive sensor (5) has an inductance (L5) of no less than 10 µH and/or of no more than 1000 mH, and/or
- wherein the capacitor (6) has an electrical capacitance (C6) of no less than 1 pF and/or of no more than 1 µF, and/or
- wherein the electrical resonant circuit (13) has a resonant frequency (fq13) of no less than 50 Hz and/or of no more than 5 MHz, and/or
- wherein the amplifier (7) has a gain/bandwidth product (VBP7) of no less than 100 kHz and/or of no more than 5 MHz.

5. Device (1) according to one of the preceding claims,
- wherein the device (1) has an electrical energy store (14), in particular a battery, wherein the electrical energy store (14) is designed to supply the inductive sensor (5), the capacitor (6), the amplifier (7), the first peak hold detector (8), the second peak hold detector (9), the evaluation device (10) and/or the communication interface (11) with electric power.

6. Device (1) according to one of the preceding claims,
- wherein the device (1) has at least one electrical resistor (R1, R2), wherein the at least one electrical resistor (R1, R2) is electrically connected to the inductive sensor (5) and/or to an input (7E) of the amplifier (7) such that the input (7E) is at a higher voltage level than 0 V when a changing magnetic flux is not registered by the inductive sensor (5).

7. Device (1) according to Claim 6,
- wherein the capacitor (6) is electrically connected to the inductive sensor (5) and/or to the input (7E) of the amplifier (7) such that the capacitor (6) assists the input (7E) to a positive voltage when the changing magnetic flux (B) is registered by the inductive sensor (5).

8. Device (1) according to one of the preceding claims,
- wherein the evaluation device (10) has an analogue-to-digital convertor (ADC), wherein the analogue-to-digital convertor (ADC) is designed to form the difference (DI) from the upper peak signal (OP) and the lower peak signal (UP).

9. Device (1) according to one of the preceding claims,
- wherein the device (1) is designed to supply the inductive sensor (5), the capacitor (6), the amplifier (7), the first peak hold detector (8) and/or the second peak hold detector (9) with electric power periodically during a wake period (twake) and not to supply it/them with electric power during a sleep period (tsleep).

10. Device (1) according to Claim 9,
- wherein the wake period (twake) is no less than 10 ms and/or no more than 1000 ms, and/or
- wherein the sleep period (tsleep) is no less than 500 ms and/or no more than 600 s.

11. Device (1) according to one of the preceding claims,
- wherein the device (1) is designed to reset the first peak hold detector (8) and the second peak hold detector (9).

12. System (50), wherein the system (50) has:
- a device (1) according to one of the preceding claims, and
- a tool (4), wherein the tool (4) has a drive motor (2, 3).

13. System (50) according to Claim 12,
- wherein the tool (4) is a manually guided, in particular handheld or soil-guided, tool.

14. System (50), wherein the system (50) has:
- a device (1) according to one of the preceding claims, and
- a terminal (12).

## Revendications

1. Dispositif (1) de détection d'un état de marche (On) d'un moteur d'entraînement (2, 3) d'un outil (4), le dispositif (1) étant conçu pour être disposé sur l'outil (4), dans lequel, dans l'état de marche (On) du moteur d'entraînement (2, 3), un flux magnétique variable (B) est provoqué, le dispositif (1) comportant :
- un capteur à induction (5), le capteur à induction (5) étant conçu pour qu'un signal de tension (IS) soit induit dans le capteur à induction (5) du flux magnétique variable (B),
- un condensateur (6), le condensateur (6) étant connecté électriquement au capteur à induction (5),
- un amplificateur (7), l'amplificateur (7) étant conçu pour amplifier le signal de tension induit (IS) ou un signal basé sur le signal de tension en un signal de tension de sortie (AS),
- un premier détecteur de maintien de pic (8) et un second détecteur de maintien de pic (9), le premier détecteur de maintien de pic (8) étant conçu pour générer un signal de pic supérieur (OP) à partir du signal de tension de sortie (AS) ou d'un signal basé sur le signal de tension de sortie, et le second détecteur de maintien de pic (9) étant conçu pour générer un signal de pic inférieur (UP) à partir du signal de tension de sortie (AS) ou du signal basé sur le signal de tension de sortie,
- un dispositif d'évaluation (10), le dispositif d'évaluation (10) étant conçu pour établir une différence (DI) à partir du signal de pic supérieur (OP) généré et du signal de pic inférieur (UP) généré, pour comparer la différence (DI) établie ou une grandeur basée sur la différence établie à une valeur de seuil (ES) réglable, la valeur de seuil (ES) étant du côté du logiciel, et pour déterminer l'état de marche (On) du moteur d'entraînement (2, 3) lorsque la valeur de seuil (ES) est atteinte ou dépassée, et
- une interface de communication (11), l'interface de communication (11) étant conçue pour envoyer sans fil à un terminal (12) l'état de marche déterminé et/ou des données de fonctionnement (BD) basées sur l'état de marche (On), et l'interface de communication (11) étant conçue pour recevoir sans fil un réglage de la valeur de seuil (ES).

2. Dispositif (1) selon la revendication 1,
- le moteur d'entraînement (2) étant un moteur d'entraînement à combustion interne et le flux magnétique variable (B) étant provoqué par une impulsion d'allumage (ZI) du moteur d'entraînement à combustion interne (2).

3. Dispositif (1) selon l'une des revendications précédentes,
- le capteur à induction (5) et le condensateur (6) constituant au moins une partie d'un circuit oscillant (13) .

4. Dispositif (1) selon l'une des revendications précédentes,
- le capteur à induction (5) présentant une inductance (L5) d'au moins 10 µH et/ou d'au plus 1000 µH, et/ou
- le condensateur (6) présentant une capacité électrique (C6) d'au moins 1 pF et/ou d'au plus 1 µF, et/ou
- le circuit oscillant électrique (13) présentant une fréquence de résonance (fq13) d'au moins 50 Hz et/ou d'au plus 5 MHz, et/ou
- l'amplificateur (7) présentant un produit gain-bande passante (VBP7) d'au moins 100 kHz et/ou d'au plus 5 MHz.

5. Dispositif (1) selon l'une des revendications précédentes,
- le dispositif (1) comportant un accumulateur d'énergie électrique (14), en particulier une batterie, l'accumulateur d'énergie électrique (14) étant conçu pour alimenter en énergie électrique le capteur à induction (5), le condensateur (6), l'amplificateur (7), le premier détecteur de maintien de pic (8), le second détecteur de maintien de pic (9), le dispositif d'évaluation (10) et/ou l'interface de communication (11).

6. Dispositif (1) selon l'une des revendications précédentes,
- le dispositif (1) comportant au moins une résistance électrique (R1, R2), ladite au moins une résistance électrique (R1, R2) étant connectée électriquement au capteur à induction (5) et/ou à une entrée (7E) de l'amplificateur (7) de telle sorte que l'entrée (7E) soit à un niveau de tension supérieur à 0 V lors d'une non-détection d'un flux magnétique variable par le capteur à induction (5).

7. Dispositif (1) selon la revendication 6,
- le condensateur (6) étant électriquement connecté au capteur à induction (5) et/ou à l'entrée (7E) de l'amplificateur (7) de telle sorte que le condensateur (6) maintienne l'entrée (7E) à une tension positive lors de la détection du flux magnétique variable (B) par le capteur à induction (5).

8. Dispositif (1) selon l'une des revendications précédentes,
- le dispositif d'évaluation (10) comportant un convertisseur analogique-numérique (ADC), le convertisseur analogique-numérique (ADC) étant conçu pour établir la différence (DI) à partir du signal de pic supérieur (OP) et du signal de pic inférieur (UP).

9. Dispositif (1) selon l'une des revendications précédentes,
- le dispositif (1) étant conçu pour alimenter le capteur à induction (5), le condensateur (6), l'amplificateur (7), le premier détecteur de maintien de pic (8) et/ou le second détecteur de maintien de pic (9) en énergie électrique de manière périodique pendant une durée d'éveil (twake) et pour ne pas les alimenter en énergie électrique pendant une durée de sommeil (tsleep).

10. Dispositif (1) selon la revendication 9,
- la durée d'éveil (twake) étant d'au moins 10 ms et/ou d'au plus 1000 ms, et/ou
- la durée de sommeil (tsleep) étant d'au moins 500 ms et/ou d'au plus 600 s.

11. Dispositif (1) selon l'une des revendications précédentes,
- le dispositif (1) étant conçu pour réinitialiser le premier détecteur de maintien de pic (8) et le second détecteur de maintien de pic (9).

12. Système (50), le système (50) comportant :
- un dispositif (1) selon l'une des revendications précédentes, et
- un outil (4), l'outil (4) comportant un moteur d'entraînement (2, 3).

13. Système (50) selon la revendication 12,
- l'outil (4) étant un outil guidé à la main, en particulier porté à la main ou guidé au sol.

14. Système (50), le système (50) comportant :
- un dispositif (1) selon l'une des revendications précédentes, et
- un terminal (12).
